# EUROPEAN PATENT APPLICATION

(11) **EP 1 615 287 A1**
(43) Date of publication of application: **11.01.2006**
(21) Application number: 05012374.4
(22) Date of filing: 08.06.2005
(51) Int. Cl.: H01M 10/04, H01M 2/02, H01M 2/22, H05K 1/14, H05K 1/18

(54) **Secondary battery, and secondary battery matrix and multi-lamination secondary battery matrix having the same**

(30) Priority: 05.07.2004 CN 200410625983
(71) Applicant: Antig Technology Co., Ltd., 114 Taipei (TW)
(72) Inventor: Chen, Cheng-Hsin, BeiTou Taipei (TW); Shen, Ko-Chen, NeiHu Taipei (TW); Shu, His-Ming, Hsin Chuang City Taipei Hsien (TW)
(74) Representative: Vossius & Partner

(57) **Abstract**

A secondary battery assembly made by PCB (Printed Circuit Board) fabrication processes, the secondary battery including: a first via and a second via, wherein the first via is electrically connected to a positive pole of the secondary battery, and the second via is electrically connected to a negative pole of the secondary battery, the first via and second via of the secondary battery being electrically laminated over and connected to a first via and a second via of another second secondary battery, respectively, so as to form a serial or parallel electrical connection between the secondary batteries.
Further a secondary battery matrix and the electrical connection between a plurality of such matrices is described.

## Description

This invention relates to a secondary battery, particularly to one made by PCB (Printed Circuit Board) fabrication processes so as to easily modularize plural secondary batteries in serial or parallel.

The conventional secondary batteries, such as Lithium rechargeable battery and Ni-H rechargeable battery, all adopt metal packaging casings, into which elements for constructing the rechargeable battery, including the positive pole, negative pole, insulation film and electrolyte substance, are packed. However, due to the limitations imposed by the metal packaging casings, if one intends to connect plural conventional secondary batteries in serial or parallel, conductive wires are usually needed, where the conductive wires are welded to the positive pole and negative pole of the every conventional secondary battery, which is then packed by an additional packaging casing, such as one made of a plastic material, to package the conventional secondary batteries that are now in serial or parallel connection together.

In view of the lack of modularization mechanism in the connection of plural conventional secondary batteries in serial or parallel, a secondary battery is thus derived, which is able to modularize plural secondary batteries in serial or parallel.

It is the first object of this invention to provide a secondary battery made by PCB (Printed Circuit Board) fabrication processes, where the secondary battery can be easily modularized in serial or parallel.

It is the second object of this invention to provide a secondary battery matrix, capable of connecting plural secondary batteries in serial or parallel to form a sheet-like secondary battery.

It is the third object of this invention to provide a multi-lamination secondary battery matrix, capable of connecting plural sheets of secondary battery matrices in serial or parallel, capable of supplying higher power wattage.

To achieve the objects of this invention, this invention discloses a secondary battery, wherein the secondary battery is made by PCB fabrication processes, the secondary battery includes a first via and a second via, wherein the first via is electrically connected the positive pole of the secondary battery, and second via is electrically connected the negative pole of the secondary battery. The first via and second via of the secondary battery are electrically laminated over and connected to a second the first via and second via of the secondary battery, respectively, so as to form serial or parallel electrical connection between the secondary batteries.

Furthermore, this invention assembled the secondary batteries above to provide a secondary battery matrix and a multi-lamination secondary battery matrix.

These and other modifications and advantages will become even more apparent from the following detained description of a preferred embodiment of the invention and from the drawings in which:
Fig. 1 illustrates a structural cross-sectional view of an embodiment of a secondary battery according to the invention;
Fig. 2 illustrates a structural cross-sectional view of a further embodiment of a secondary battery according to the invention;
Fig. 3 illustrates a structural schematic view of a secondary battery according to the invention prior to lamination;
Fig. 4 illustrates a structural schematic view of a secondary battery according to the invention subsequent to lamination;
Fig. 5 illustrates a structural view of a secondary battery matrix according to the invention; and
Fig. 6 illustrates a structural view of a multi-lamination secondary battery matrix according to the invention.

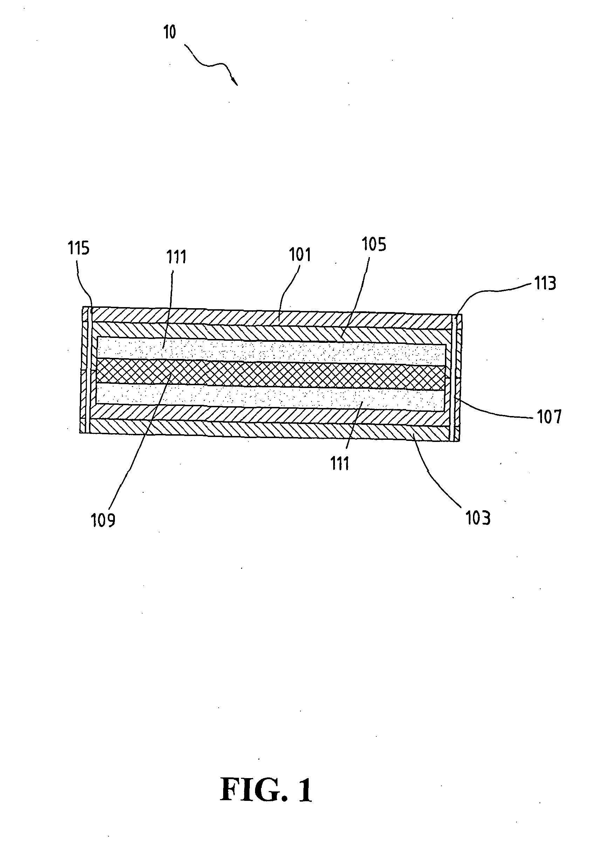

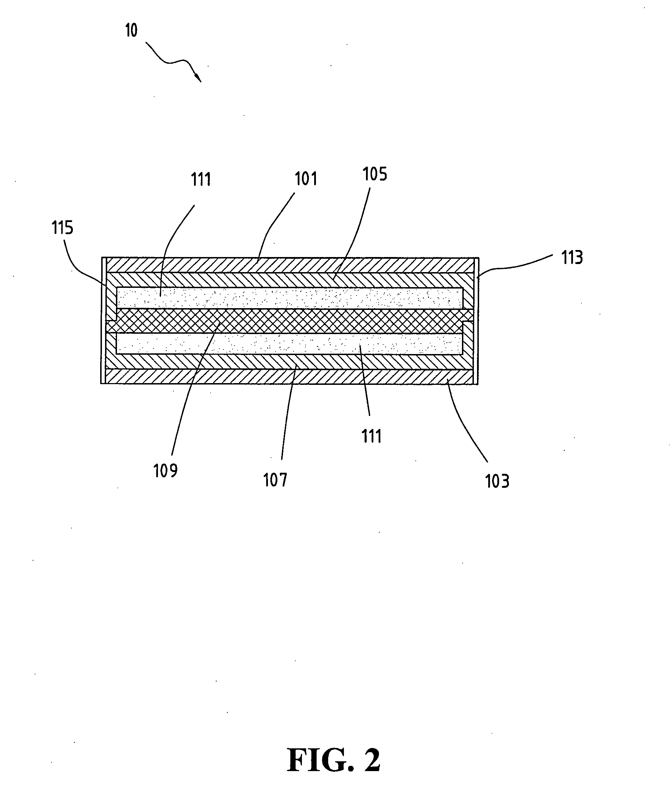

Fig. 1 illustrates a structural cross-sectional view of an embodiment of a secondary battery according to the invention, and Fig. 2 illustrates the structural cross-sectional view of a further embodiment of a secondary battery according to the invention. The secondary battery 10 of this invention includes: an upper casing 101, an upper receiving compartment 105, a secondary battery core assembly 109, a lower receiving compartment 107 and a lower casing 103. These elements are sequentially laminated from top to bottom to form a packed configuration. Other than the secondary battery core assembly 109, the other elements of this invention are made by the processes for manufacturing PCB (Printed Circuit Board) materials. The PCB materials as adopted may be of FR4 substance. In the process of assembling the secondary battery 10 of this invention, the upper receiving compartment 105 and lower receiving compartment 107 serve to accommodate electrolyte substance 111. The secondary battery core assembly 109 is sandwiched between the upper receiving compartment 105 and lower receiving compartment 107, by means of such lamination measures as pressing and adhesion, to laminate the secondary battery core assembly 109, upper receiving compartment 105 and lower receiving compartment 107 over one another. The upper casing 101 then covers over and seals the upper receiving compartment 105, and lower casing 103 covers over and seals the lower receiving compartment 107, by means of such lamination measures as pressing and adhesion. The selection of the above electrolyte substance 111 is dependent on the type of secondary battery core assembly 109 as employed. For example, the electrolyte substance or electrolyte solution may be replaced with organic solvent or hydro-free electrolyte or electrolyte solution, or electrolyte material that may be applied by jetting or coating.

In Fig. 1, the first via 113 penetrates the PCB material and is electrically connected to a positive pole of the secondary battery core assembly 109. Similarly, the second via 115 penetrates the PCB material and is electrically connected to a negative pole of the secondary battery core assembly 109. In Fig. 2, the first via 113 is provided to and exposed from a peripheral edge of the PCB material, and electrically connected to the positive pole of the secondary battery core assembly 109. Similarly, the second via 115 is provided to and exposed from the peripheral edge of the PCB material and electrically connected to the negative pole of the secondary battery core assembly 109.

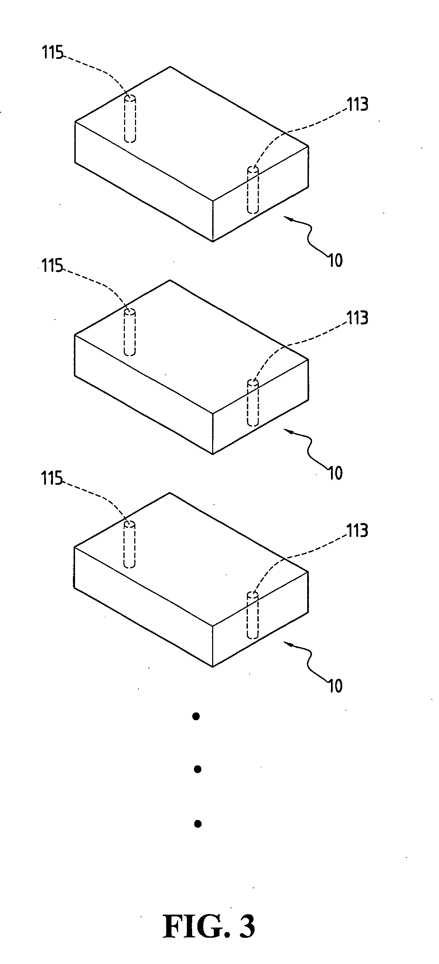

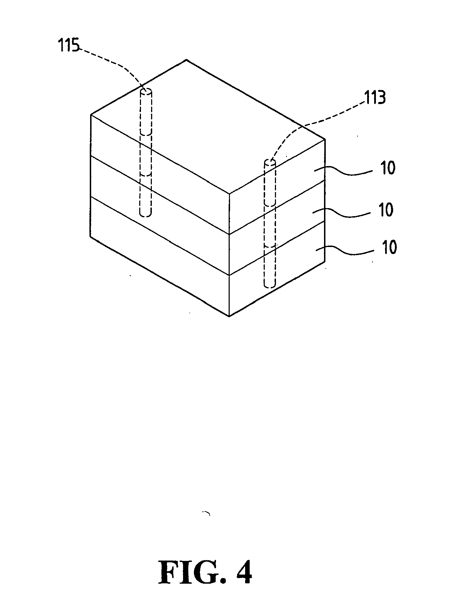

Fig. 3 illustrates a structural schematic view of a secondary battery according to the invention prior to lamination, and Fig. 4 illustrates a structural schematic view of a secondary battery according to the invention subsequent to lamination. In the process of assembling the lamination, the first via 113 and second via 115 of all secondary batteries 10 aligned to each other, such as aligning the first vias 113 and second vias 115 of all secondary batteries 10 to one another, such that all secondary batteries 10 are connected to each other in parallel. Alternatively, the first via 113 of a secondary battery 10 may be aligned with a second via 115 of a neighboring secondary battery 10, such that all secondary batteries 10 are connected in serial. Then, a conductive material, such as silver adhesive, is then injected into the vias 113, 115 that are aligned to each other so as to form a serial or parallel electrical connection among these secondary batteries 10.

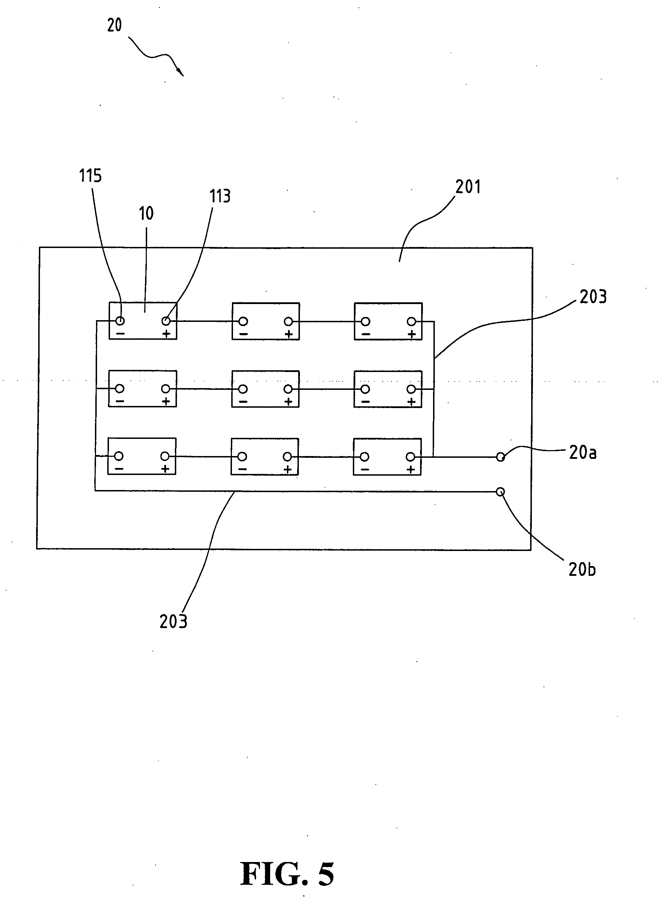

Fig. 5 illustrates a structural view of a secondary battery matrix according to the invention. The secondary battery matrix 20 of this invention includes: plural secondary batteries 10 and a PCB (Printed Circuit Board) 201. The PCB 201 is formed with a serial/parallel circuitry 203. The serial/parallel circuitry 203 connects all secondary batteries 10 welded to the PCB 201 in serial or parallel. Furthermore, the PCB 201 further includes a common positive pole terminal 20a and a common negative pole terminal 20b to be connected to external electronic devices, to which electrical power is supplied.

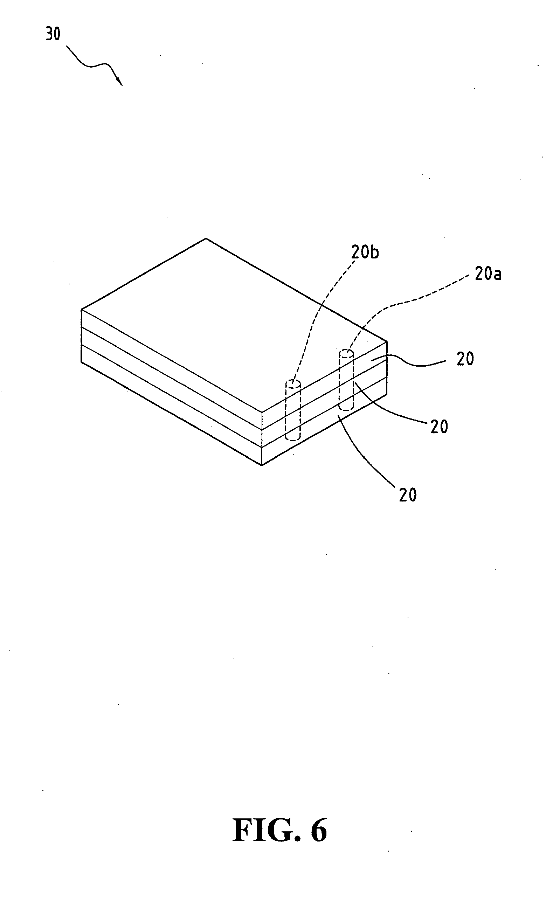

Fig. 6 illustrates a structural view of a multi-lamination secondary battery matrix according to the invention. The multi-lamination secondary battery matrix 30 of this invention includes: plural secondary battery matrices 20. The multi-lamination secondary battery matrix 30 is constructed by laminating the secondary battery matrices 20 to one another, such as packing plural sheets of secondary battery matrix 20 from top to bottom to form a multi-lamination secondary battery matrix 30. The common positive pole terminal 20a and common negative pole terminal 20b of each secondary battery matrix 20 are connected to the common positive pole terminal 20a and common negative pole terminal 20b of the two neighboring secondary battery matrices 20 in serial or parallel. Similarly, the measures of vias are also adopted to connect the common positive pole terminals 20a and common negative pole terminals 20b of all sheets the secondary battery matrix 20 to one another.

The secondary battery , secondary battery matrix and multi-lamination secondary battery matrix of the invention achieve the following efficacies
1. The secondary battery of the invention is provided with vias such that plural secondary batteries may be laminated to form a packed construction with serial or parallel electrical connection, while rendering the appearance of single-unit secondary battery;
2. The secondary battery matrix of the invention is of a sheet-like configuration by means of the PCB and the serial/parallel circuitry formed thereto; and
3. The multi-lamination secondary battery matrix of the invention provides a secondary battery configuration that is able to supply a higher power wattage through the plural sheets of secondary battery matrix that are laminated to form a packed construction with serial or parallel electrical connection.

This invention is related to a novel creation that makes a breakthrough in the art. Aforementioned explanations, however, are directed to the description of preferred embodiments according to this invention. Since this invention is not limited to the specific details described in connection with the preferred embodiments, changes and implementations to certain features of the preferred embodiments without altering the overall basic function of the invention are contemplated within the scope of the appended claims.

## Claims

1. A secondary battery made by PCB (Printed Circuit Board) fabrication processes, the secondary battery including: a first via and a second via, wherein the first via is electrically connected to a positive pole of the secondary battery, and the second via is electrically connected to a negative pole of the secondary battery, the first via and second via of the secondary battery being electrically laminated over and connected to a first via and a second via of another second secondary battery, respectively, so as to constitute so as to form serial or parallel electrical connection between the secondary batteries.

2. The secondary battery of claim 1, wherein the secondary battery comprises:
an upper casing in a form of a PCB (Printed Circuit Board) material;
an upper receiving compartment in a form of a PCB material;
a secondary battery core assembly;
a lower receiving compartment in a form of a PCB material;
a lower casing in a form of a PCB material;
wherein the above are sequentially laminated from top to bottom to form a packed configuration.

3. The secondary battery of claim 2, wherein the first via is formed to penetrate the upper casing, the upper receiving compartment, the lower receiving compartment and the lower casing.

4. The secondary battery of claim 2 or 3, wherein the second via is formed to penetrate the upper casing, the upper receiving compartment, the lower receiving compartment and the lower casing.

5. The secondary battery of claim 2, 3 or 4, wherein the first via is formed to penetrate along and expose from peripheral edges of the upper casing, the upper receiving compartment, the lower receiving compartment and the lower casing.

6. The secondary battery of claim 2, 3, 4 or 5, wherein the second via is formed to penetrate along and expose from peripheral edges of the upper casing, the upper receiving compartment, the lower receiving compartment and the lower casing

7. A secondary battery matrix, comprising:
plural secondary batteries made by PCB (Printed Circuit Board) fabrication processes, the secondary battery each including a first via and a second via, wherein the first via is electrically connected to a positive pole of the secondary battery, and the second via is electrically connected to a negative pole of the secondary battery;
a PCB having a serial/parallel circuitry, wherein the serial/parallel circuitry is formed to the PCB, and the first via and second via of the secondary battery are welded to the serial/parallel circuitry, so as to form serial or parallel electrical connection between the secondary batteries.

8. A multi-lamination secondary battery matrix, comprising:
plural secondary battery matrices of a lamination configuration, wherein the secondary battery matrices each include:
plural secondary batteries made by PCB fabrication processes, the secondary battery including a first via and a second via, wherein the first via is electrically connected to a positive pole of the secondary battery, and the second via is electrically connected to a negative pole of the secondary battery;
a PCB having a serial/parallel circuitry, wherein the serial/parallel circuitry is formed to the PCB, and the first via and second via of the secondary battery are welded to the serial/parallel circuitry;
wherein the PCB of each secondary battery matrix is electrically connected to the PCB of a neighboring secondary battery matrix electrically connected, so as to form serial or parallel electrical connection between the secondary battery matrices.
